# EUROPÄISCHE PATENTANMELDUNG

(11) **EP 1 009 023 A1**
(43) Veröffentlichungstag der Anmeldung: **14.06.2000**
(21) Anmeldenummer: 98811216.5
(22) Anmeldetag: 09.12.1998
(51) Int. Cl.: H01L 21/48, H01L 23/498, H01L 23/538

(54) **Verfahren zur Verbindung von zwei Leiterstrukturen und Kunststoffobjekt**

(71) Anmelder: ESEC Management SA, 6330 Cham (CH); Sempac SA, 6330 Cham (CH)
(72) Erfinder: Bauknecht, Raimond, 8005 Zürich (CH); Betschart, Alois, 6318 Walchwil (CH); Ragg, Wolfram, 6332 Hagendorn (CH)

(57) **Zusammenfassung**

Ein Verfahren zur Verbindung von zwei Leiterstrukturen (1, 3) umfasst die folgenden Schritte:
- Aufbringen elektrisch leitender Bumps (2) auf die erste Leiterstruktur (1);
- Anbringen von Durchbrüchen (4) oder Ausbrüchen (9) auf der zweiten Leiterstruktur (3);
- Plazieren der ersten Leiterstruktur (1) über der zweiten Leiterstruktur (3), wobei sich die Durchbrüche (4) bzw. Ausbrüche (9) örtlich über den Bumps (2) befinden;
- Verformen der Bumps (2), damit die Bumps (2) die erste Leiterstruktur (1) an den Durchbrüchen (4) bzw. Ausbrüchen (9) der zweiten Leiterstruktur (3) fixieren und damit die beiden Leiterstrukturen (1, 3) in elektrischem Kontakt sind.

## Beschreibung

Die Erfindung betrifft ein Verfahren zur Verbindung von zwei Leiterstrukturen und ein Kunststoffobjekt mit einer derart hergestellten Verbindung.

Ein solches Verfahren eignet sich beispielsweise zur Verbindung der Anschlüsse eines Elektronikmoduls mit einer auf einer Folie aufgebrachten Antenne, wie sie bei Chipkarten, Tags und dergleichen gebräuchlich sind.

Der Erfindung liegt die Aufgabe zugrunde, zwei Leiterstrukturen aneinander zu fixieren und einen elektrischen Kontakt zwischen ihnen herzustellen.

Die Erfindung ist in den Ansprüchen 1 und 2 gekennzeichnet.

Nachfolgend werden Ausführungsbeispiele der Erfindung anhand der Zeichnung näher erläutert.

Es zeigen:
- Fig. 1-4: mittels eines Bumps zu verbindende bzw. verbundene Leiterstrukturen,
- Fig. 5: einen zweiteiligen Stempel,
- Fig. 6: mit Durchbrüchen oder Ausbrüchen versehene Leiterstrukturen,
- Fig. 7: ein Kunststoffobjekt, und
- Fig. 8, 9: ein weiteres Kunststoffobjekt.

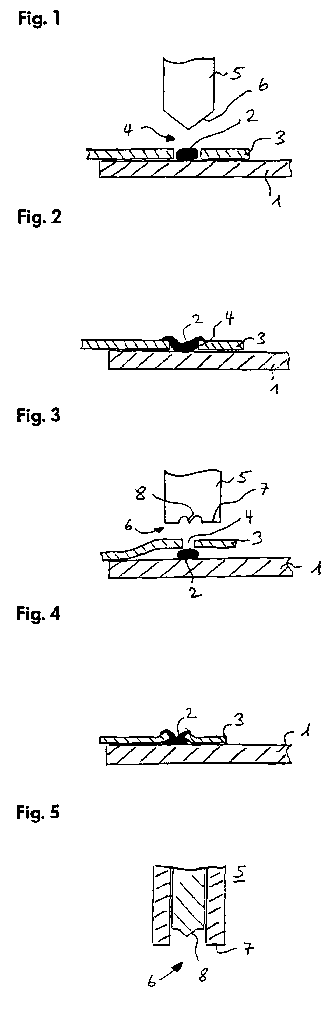

Die Fig. 1 zeigt im Querschnitt eine erste Leiterstruktur 1, auf die beispielsweise mittels eines Wire Bonders ein sogenannter Bump 2 aufgebracht worden ist. Bei diesem Prozess wird aus dem an der Mündung einer Kapillare herausragenden Drahtstück eine Kugel geschmolzen und diese Kugel mit Ultraschall, Wärme und Druck auf der ersten Leiterstruktur 1 befestigt. Die Kugel kann dabei durch die Kapillare flachgedrückt werden. Es ist auch möglich, zwei oder mehr Bumps 2 übereinander zu plazieren und dadurch einerseits die abgeschiedene Materialmenge und andererseits die Höhe des abgeschiedenen Materials zu verdoppeln. Als Material für die Bumps 2 eignet sich insbesondere Gold. Der typische Durchmesser D des Bumps 2 beträgt 150 µm, die typische Höhe H beträgt 30 - 50 µm. Werden zwei Bumps 2 übereinander plaziert, dann vorzugsweise derart, dass sich ein etwa konischer Verlauf mit einer nach oben gerichteten Spitze des gesamten Bumps 2 ergibt.

Die Bumps 2 können auch galvanisch auf die erste Leiterstruktur 1 aufgebracht werden.

Über der ersten Leiterstruktur 1 befindet sich eine zweite Leiterstruktur 3, die an der ersten Leiterstruktur 1 zu befestigen und zu kontaktieren ist. Die zweite Leiterstruktur 3 weist einen Durchbruch 4 auf, dessen Durchmesser grösser als der Durchmesser des Bumps 2 ist. Die zweite Leiterstruktur 3 ist so über der ersten Leiterstruktur 1 plaziert, dass der Bump 2 in den Durchbruch 4 hineinragt. Mittels eines Stempels 5, der vorzugsweise eine konisch ausgebildete Stempelfront 6 aufweist, wird der Bump 2 nun verformt, so dass der Bump 2, wie in der Fig. 2 dargestellt, über den Rand des Durchbruches 4 der zweiten Leiterstruktur 3 hinausragt und im Durchbruch 4 verstemmt ist und somit die zweite Leiterstruktur 3 in gutem mechanischem und elektrischem Kontakt gegen die erste Leiterstruktur 1 presst.

Die Fig. 3 zeigt eine Variante, bei der der Durchmesser des Durchbruches 4 der zweiten Leiterstruktur 3 kleiner als der Durchmesser des Bumps 2 ist. Die Front 6 des Stempels 5 weist daher eine zur Ebene der ersten Leiterstruktur 1 parallele Randfläche 7 auf, mit der die zweite Leiterstruktur 3 gegen den Bump 2 und gegen die erste Leiterstruktur 1 gedrückt werden kann. Die Stempelfront 6 weist weiter eine in der Mitte zentrierte Nadelspitze 8 auf, die ihrerseits den Bump 2 gegen den Rand des Durchbruches 4 presst. Es resultiert eine Verbindung zwischen der ersten und zweiten Leiterstruktur 1 bzw. 3, bei der der Rand des Durchbruches 4, wie in der Fig. 4 dargestellt, verbogen ist.

Möglich ist auch die Verwendung eines zweiteiligen Stempels 5, bei dem, wie in der Fig. 5 gezeigt ist, die Randfläche 7 der Stempelfront 6 und die Nadelspitze 8 getrennt verschiebbar sind. So kann zuerst die Leiterstruktur 3 gegen den Bump 2 und gegen die erste Leiterstruktur 1 gepresst werden und daran anschliessend kann der Bump 2 weiter verformt und im Durchbruch 4 verstemmt werden.

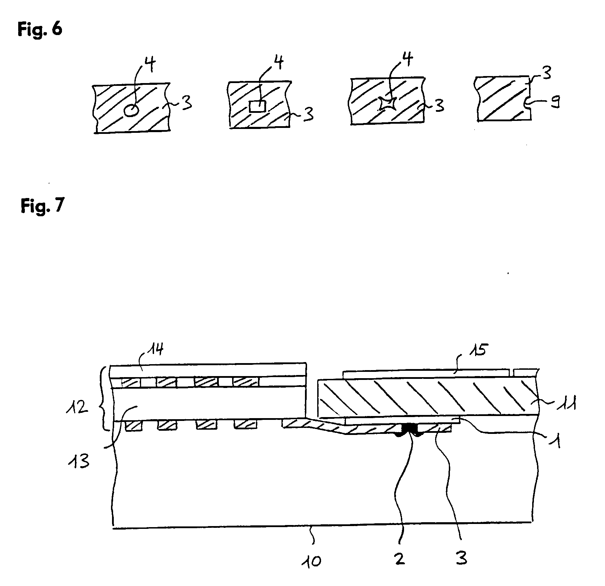

Die Fig. 6 zeigt besonders bevorzugte Formen des Durchbruchs 4 in der Draufsicht: kreisförmig, rechteckförmig, insbesondere quadratisch, oder mit gegen das Zentrum des Durchbruchs 4 gerichteten Zungen. Im letzten in der Fig. 6 dargestellten Beispiel ist ein Ausbruch 9 dargestellt, der anstelle eines Durchbruches 4 zur Herstellung einer Verbindung zwischen den beiden Leiterstrukturen 1, 3 verwendet werden könnte.

Die Fig. 7 zeigt ein Kunststoffobjekt 10, für dessen Herstellung dieses Verfahren geeignet ist. Die erste Leiterstruktur 1 ist Teil eines Elektronikmoduls 11. Die zweite Leiterstruktur 3 ist Teil einer Folie 12, die z.B. als Laminat aus mehreren Folien 13, 14 aufgebaut ist. Die erste Folie 13 ist einseitig, vorzugsweise beidseitig mit einer Metallfolie, beispielsweise einer Kupferfolie, kaschiert oder durch Klebstoff verbunden, wobei die eine Kupferfolie die zweite Leiterstruktur 3 bildet. Die Folie 12 und das Elektronikmodul 11 sind in einer Spritzgussform zum Kunststoffobjekt 10 zusammengefügt worden, das beispielsweise eine runde Form in der Grösse einer Münze oder Uhr aufweist. Die Folie 12 bildet eine Aussenfläche des Kunststoffobjektes 10. Die Folie 12 weist eine Öffnung auf, die der Form des Elektronikmoduls 11 angepasst ist und in der das Elektronikmodul 11 plaziert ist. Eine mit einer dritten Leiterstruktur 15 versehene Aussenfläche des Elektronikmoduls 11 bildet dabei eine von aussen kontaktierbare Kontaktfläche des Kunststoffobjektes 10. Die Bumps 2 sind auf der ersten Leiterstruktur 1 aufgebracht. Die zweite Leiterstruktur 3, die eine spulenförmige Antenne umfasst, ragt seitlich in die Öffnung der Folie 12 hinein, so dass das noch unbefestige Elektronikmodul 11 beim Plazieren innerhalb der Öffnung der Folie 12 auf der zweiten Leiterstruktur 3 aufliegt. Die Bumps 2 ragen dann in die entsprechend angebrachten Durchbrüche 4 hinein. In der Fig. 7 ist der Zustand dargestellt, in dem die beiden Leiterstrukturen 1 und 3 bereits aneinander fixiert sind.

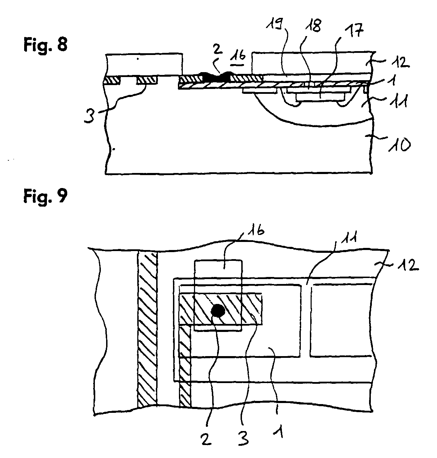

Die Fig. 8 und 9 zeigen ausschnittsweise ein kontaktloses Kunststoffobjekt 10 mit einem Elektronikmodul 11 und einer Folie 12. Das Elektronikmodul 11 weist die erste Leiterstruktur 1 auf, die bei der Herstellung des Kunststoffobjektes 10 mit einer Antenne zu verbinden ist. Die Antenne ist als zweite Leiterstruktur 3 auf der gegen das Innere des Kunststoffobjektes 10 gerichteten Seite der Folie 12 aufgebracht. Die beiden Leiterstrukturen 1 und 3 sind miteinander durch mindestens einen Bump 2 mechanisch und elektrisch verbunden. Die Folie 12 weist eine Öffnung 16 auf, in die beim Verformen des Bumps 2 der hier nicht dargestellte Stempel 5 eingreift. Die Öffnung 16 erstreckt sich, wie in der Fig. 9 ersichtlich ist, über den Rand des Elektronikmoduls 11 hinaus, so dass die Öffnung 16 beim Vergiessen zum Kunststoffobjekt 10 mit Kunststoff gefüllt wird.

Der Hohlraum 19 zwischen der Folie 12 und der zweiten Leiterstruktur 3 ist bevorzugt mit einer Blindleiterstruktur oder einem Kleb- oder Füllstoff gefüllt.

Das Elektronikmodul 11 kann ein TM-Gehäuse aufweisen. Solche Elektronikmodule sind im Handel z.B. von Siemens unter der Bezeichnung MCC2 oder von Philips unter der Bezeichnung MOA 1 erhältlich. Das Elektronikmodul 11 kann aber auch die in der Fig. 8 dargestellte Struktur aufweisen, bei der ein Halbleiterchip 17 mit der ersten Leiterstruktur 1 verdrahtet ist. Dabei sind der Halbleiterchip 17 und die erste Leiterstruktur 1 durch eine elektrisch isolierende Folie 18 aus Epoxy getrennt.

## Patentansprüche

1. Verfahren zur Verbindung von zwei Leiterstrukturen (1, 3), das die folgenden Schritte umfasst:
- Aufbringen elektrisch leitender Bumps (2) auf die erste Leiterstruktur (1);
- Anbringen von Durchbrüchen (4) oder Ausbrüchen (9) auf der zweiten Leiterstruktur (3);
- Plazieren der ersten Leiterstruktur (1) über der zweiten Leiterstruktur (3), wobei sich die Durchbrüche (4) bzw. Ausbrüche (9) örtlich über den Bumps (2) befinden;
- Verformen der Bumps (2), damit die Bumps (2) die erste Leiterstruktur (1) an den Durchbrüchen (4) bzw. Ausbrüchen (9) der zweiten Leiterstruktur (3) fixieren und damit die beiden Leiterstrukturen (1, 3) in elektrischem Kontakt sind.

2. Kunststoffobjekt (10), umfassend eine Folie (12) und ein Elektronikmodul (11), bei dem das Elektronikmodul (11) eine erste Leiterstruktur (1) aufweist, bei dem die gegen das Innere des Kunststoffobjektes (10) gerichtete Seite der Folie (12) eine als Antenne ausgebildete zweite, mit Durchbrüchen (4) und/oder Ausbrüchen (9) versehene Leiterstruktur (3) aufweist, und bei dem die beiden Leiterstrukturen (1, 3) durch in Durchbrüche hineinragende, verformte Bumps aneinander fixiert und elektrisch kontaktiert sind.

3. Kunststoffobjekt (10) nach Anspruch 2, **dadurch gekennzeichnet, dass** das Elektronikmodul (11) in einer Öffnung der Folie (12) plaziert ist und mit einer dritten Leiterstruktur (15) versehen ist, die eine von aussen kontaktierbare Kontaktfläche bildet.
